# FASCICULE DE BREVET EUROPEEN

(11) **EP 4 414 716 B1**
(45) Date de publication et mention de la délivrance du brevet: **21.10.2026**
(21) Numéro de dépôt: 24157083.7
(22) Date de dépôt: 12.02.2024
(51) Int. Cl.: G01R 15/18

(54) **MODULE DE MESURE DE COURANT ÉLECTRIQUE**
STROMMESSMODUL
ELECTRIC CURRENT MEASURING MODULE

(30) Priorité: 13.02.2023 FR 2301313
(43) Date de publication de la demande: 14.08.2024
(73) Titulaire: Schneider Electric Industries SAS, 92500 Rueil-Malmaison (FR)
(72) Inventeur: RONDOT, Loïc, 38240 Meylan (FR); KOCH, Juliette, 38100 Grenoble (FR)
(74) Mandataire: Lavoix

(56) Documents cités:
- DE-U1- 20 080 180
- FR-A1- 2 891 946
- US-A1- 2013 002 236

## Description

La présente invention concerne un module de mesure de courant électrique.

L'invention se situe dans le domaine des dispositifs de mesure de grandeurs électriques.

Les installations électriques, par exemple les réseaux locaux de distribution d'électricité, adaptés pour la distribution d'électricité dans un bâtiment, comportent en général plusieurs charges, et le cas échéant plusieurs sources, connectées par des conducteurs électriques.

Il existe un besoin d'assurer la supervision, le bon fonctionnement et la sécurité des telles installations électriques, et pour ce faire, il est utile de fournir des moyens de mesures de grandeurs électriques permettant de caractériser les signaux électriques circulant dans les conducteurs électriques, par des mesures de grandeurs électriques.

En particulier, la mesure de courant permet d'assurer la sécurité en permettant de déclencher l'actionnement de dispositifs de protection comme par exemple des disjoncteurs.

Ainsi, la mise en œuvre de dispositifs de mesure de courant est un problème récurrent dans le domaine de la supervision des installations électriques.

Dans le domaine des dispositifs de mesure de courant, en particulier pour la mesure de courant alternatif ou d'impulsions de courant, on connaît des dispositifs utilisant un enroulement de fil conducteur hélicoïdal, également appelé bobinage, dits capteurs de Rogowski. L'enroulement est de préférence de forme circulaire, formant un anneau à l'intérieur duquel est positionné le conducteur électrique traversé par le courant électrique à mesurer. La tension induite dans l'enroulement est proportionnelle au taux de changement, en d'autres termes à la dérivée temporelle, du courant circulant dans le conducteur. La forme circulaire de l'enroulement, avec des spires équidistantes, présente les meilleures propriétés d'un point de vue théorique, mais est difficile à réaliser en pratique.

Dans des variantes, le capteur de courant est formé à partir de plusieurs enroulement linéaires, disposés par exemple en carré et formant un espace central de passage du conducteur électrique. Cependant, dans un tel agencement il est difficile de garantir l'immunité du capteur à des sources de courant autres que le conducteur électrique dont on cherche à mesurer le courant. Classiquement, on place dans les angles des spires supplémentaires pour capter le flux dans les angles.

Il existe des capteurs de Rogowski ouvrants, comportant des enroulements sur une armature souple, ce qui permet d'insérer plus facilement le conducteur électrique de manière centrée entre les enroulements du capteur, sans avoir à débrancher le conducteur électrique. Cela présente l'avantage de faciliter et de gagner du temps lors la mise en place de tels capteurs.

FR 2 891 946 A1 divulgue un capteur de courant ouvrant comportant un enroulement principal, détachable d'un élément ferromagnétique ayant deux bras et une portion centrale arrondie.

Cependant, les capteurs de ce type connus sont peu compacts, leur encombrement ne permettant pas leur intégration dans de petits tableaux électriques.

Il existe donc un besoin de fournir des dispositifs de mesure de courant ouvrants, performants et robustes, tout en étant faciles à fabriquer et compacts.

A cet effet, l'invention propose, selon un aspect, un module de mesure de courant selon la revendication 1.

Avantageusement, le module de mesure de courant électrique proposé est compact et robuste, grâce à l'agencement de l'enroulement principal et de l'élément ferromagnétique associé.

Le module de mesure de courant selon l'invention peut présenter une ou plusieurs des caractéristiques ci-dessous, prises indépendamment ou selon toutes les combinaisons acceptables.

L'enroulement principal est réalisé par enroulement d'un fil conducteur sur un support de forme linéaire.

Chacun desdits bras a une extrémité située à l'opposé de la portion centrale arrondie, et l'enroulement principal est disposé à une même distance, selon la direction de l'axe de symétrie, de l'extrémité de chaque bras.

La première partie est formée par l'enroulement principal et la deuxième partie est formée par l'élément ferromagnétique (ces caractéristiques ne sont pas revendiquées).

La portion centrale arrondie de l'élément ferromagnétique forme ladite deuxième partie, séparable de chacun desdits bras, la première partie étant formée par les bras et l'enroulement principal fixé entre lesdits bras.

L'enroulement principal a une première extrémité et une deuxième extrémité, lesdits bras de l'élément ferromagnétique étant respectivement un premier bras et un deuxième bras, le module de mesure comportant en outre des enroulements de compensation, disposés de part et d'autre de l'enroulement principal, respectivement entre la première extrémité de l'enroulement principal et le premier bras et entre la deuxième extrémité de l'enroulement principal et le deuxième bras.

La portion centrale arrondie a une forme rectangulaire à coins arrondis dans un plan longitudinal de l'élément ferromagnétique.

La portion centrale arrondie a une forme d'arc de cercle dans un plan longitudinal de l'élément ferromagnétique.

L'élément ferromagnétique est un alliage de fer-silicium ou de fer-nickel.

Le module comporte en outre circuit de traitement, le fil conducteur de l'enroulement principal étant connecté au circuit de traitement, le circuit de traitement comportant notamment un intégrateur du signal électrique.

D'autres caractéristiques et avantages de l'invention ressortiront de la description qui en est donnée ci-dessous, à titre indicatif et nullement limitatif, en référence aux figures annexées, parmi lesquelles :
- la figure 1 représente schématiquement un module de mesure de courant électrique selon un mode de réalisation ;
- la figure 2 représente un détail de la figure 1 ;
- la figure 3 représente schématiquement un capteur de courant d'un module de mesure de courant électrique selon une variante non revendiquée.

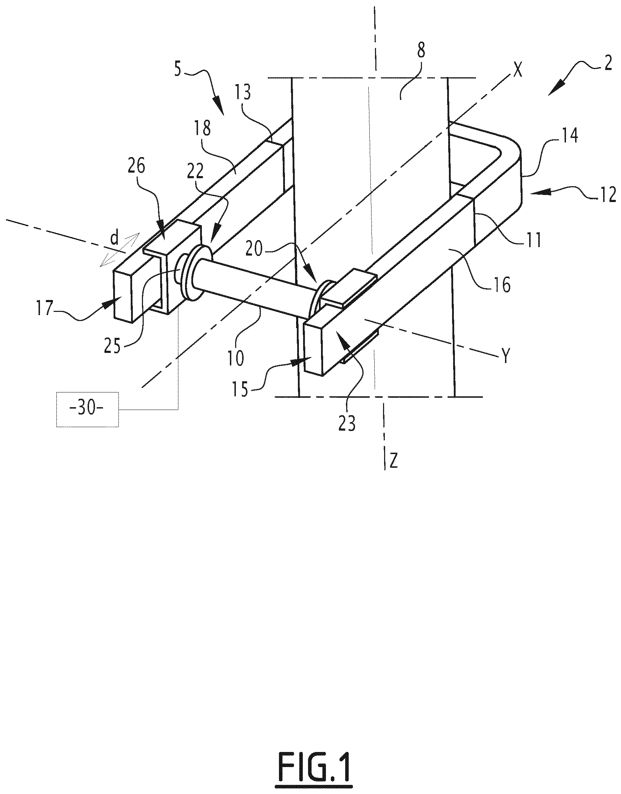

Des modes de réalisation d'un module de mesure de courant électrique sont décrits ci-après en référence aux figures 1 à 3.

La figure 1 illustre schématiquement un module 2 de mesure de courant selon un mode de réalisation, destiné à réaliser en continu une mesure du courant traversant le conducteur électrique 8.

Le conducteur électrique 8 fait partie d'une installation électrique (non représentée) dans laquelle le module 2 de mesure de courant peut être positionné pour réaliser la mesure de courant.

Le module 2 de mesure de courant comprend un capteur de courant inductif 5 comportant un enroulement principal 10 de fil conducteur, également appelé bobinage principal 10, par exemple de forme linéaire, i.e. réalisé par enroulement hélicoïdal du fil conducteur autour d'un support de forme linéaire. Par exemple, le support a une section circulaire.

En variante, la forme du bobinage peut être incurvée, par exemple réalisée par enroulement hélicoïdal d'un fil conducteur autour d'une portion de tore.

Le fil conducteur est par exemple un fil de cuivre, le support étant en matériau plastique, par exemple en polymère à cristaux liquides (ou LCP).

Le capteur 5 comporte en outre un élément ferromagnétique 12 de formé incurvée. Le capteur 5 ainsi formé est un capteur dit de Rogowski hybride.

L'élément ferromagnétique 12 a une forme de « C » inversé dans les figures illustrées, comportant une portion centrale arrondie 14, ayant un axe de symétrie X, et deux bras, respectivement un premier bras 16 et un deuxième bras 18 s'étendant de manière symétrique, parallèlement à l'axe de symétrie X de la portion centrale arrondie 12.

De préférence, les deux bras 16, 18 sont linéaires et de mêmes dimensions, e.g. de même longueur, épaisseur, hauteur.

Dans l'exemple illustré les bras 16, 18 ont une section rectangulaire.

Chacun des bras 16, 18 a une première extrémité 11, 13 située en regard de la portion centrale arrondie et une deuxième extrémité 15, 17, opposée à la première extrémité 11, 13.

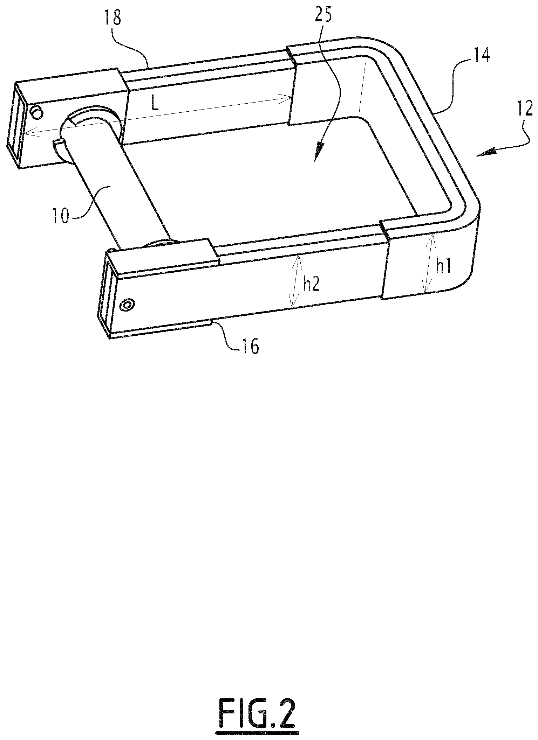

Dans un mode de réalisation, comme visible dans le détail de la figure 2, la portion centrale arrondie 14 a une hauteur h1 et chacun des bras 16, 18 a une hauteur h2, la hauteur h2 étant inférieure à h1.

En variante, les hauteurs h1 et h2 sont égales, ou bien la hauteur h2 est supérieure à la hauteur h1.

Dans un mode de réalisation, la portion centrale arrondie 14 et les bras 16, 18 ont une épaisseur de matériau ferromagnétique, de préférence comprise entre 0,3 mm à 4mm.

Dans un mode de réalisation, l'élément ferromagnétique 12 est réalisé sous forme d'une pluralité de couches de matériau empilées.

L'élément ferromagnétique 12 est par exemple réalisé en acier, e.g. un alliage fer-nickel ou fer-silicium, ces matériaux ayant une perméabilité importante.

Dans les modes de réalisation illustrés, l'enroulement principal 10 est disposé selon un axe Y, orthogonal à l'axe de symétrie X, à proximité spatiale des deuxièmes extrémités 15, 17 des bras 16, 18.

Par exemple, l'enroulement principal 10 est disposé à une même distance d supérieure ou égale à 1 mm, et de préférence supérieure ou égale à 2 mm des deuxièmes extrémités 15, 17 des bras 16, 18.

Dans un mode de réalisation, la distance d est de l'ordre de grandeur du diamètre de l'enroulement principal.

Ainsi, l'agencement de l'enroulement principal et de l'élément ferromagnétique permet de former un logement traversant 25 adapté pour accueillir et entourer le conducteur électrique 8.

De préférence, l'élément ferromagnétique 12 a une forme géométrique symétrique par rapport à l'axe de symétrie X.

Dans le mode de réalisation illustré dans les figures 1 et 2, la portion centrale arrondie 14 a une forme rectangulaire à coins arrondis, dans un plan longitudinal de l'élément ferromagnétique 12 (plan X, Y dans la figure 1).

Le capteur 5 du module 2 est agencé en deux parties, de manière à permettre une ouverture et une fermeture ultérieure, et par conséquent faciliter la mise en place du module 2 autour du conducteur électrique 8.

Dans le mode de réalisation de la figure 1, les bras 16, 18 sont séparables de la portion centrale arrondie 14, ce qui permet avantageusement une ouverture du capteur par séparation entre les bras et la portion centrale arrondie, pour permettre d'entourer un conducteur électrique.

En d'autres termes, dans ce mode de réalisation le capteur 5 est un capteur ouvrant formé de deux parties séparables, permettant l'ouverture et la fermeture du capteur autour du conducteur électrique.

Dans le mode de réalisation de la figure 1, les bras 16, 18 et l'enroulement principal forment une première partie du capteur, la portion centrale arrondie 14 de l'élément ferromagnétique 12 formant une deuxième partie du capteur.

Par exemple, les bras 16, 18 sont fixés sur le support du bobinage principal par bouterollage.

Plusieurs modes d'ouverture mécanique sont envisageables entre la première partie et la deuxième partie du capteur, par exemple en mettant en oeuvre un pivot, ou par translation en association avec un élément de fermeture mécanique (par exemple par encliquetage).

Le module 2 comporte en outre dans des modes de réalisation des enroulements de compensation 20, 22, disposés de part et d'autre de l'enroulement principal 10, entre chaque extrémité 23 25 de l'enroulement principal 10 et les bras 16, 18 de l'élément ferromagnétique 62, de manière à assurer une compensation magnétique des jeux mécaniques, notamment entre le support de bobinage et l'élément ferromagnétique.

Les enroulements de compensation 20, 22 sont de préférence symétriques.

Chaque enroulement de compensation 20, 22 comprend un même nombre de spires, ce nombre étant par exemple déterminé par mesure ou simulation des performances du capteur, de manière à optimiser les performances. Par exemple, des conducteurs perturbateurs sont placés à proximité du capteur lors de la simulation, et le nombre de spires des enroulements de compensation est celui qui permet d'obtenir des résultats les moins sensibles aux conducteurs perturbateurs.

Par exemple, chaque enroulement de compensation comporte entre 80 et 100 spires.

L'ensemble des enroulements, ie l'enroulement principal 10 et les enroulements de compensation 20, 22, forment un enroulement ou bobinage de mesure du courant électrique.

Dans un mode de réalisation, l'enroulement principal est fixé aux bras respectifs 16, 18 au moyen de pièces de fixation 26, qui sont par exemple en matériau plastique, par exemple du LCP (polymère cristaux-liquides).

Ainsi, dans ce mode de réalisation, les bras 16, 18 et l'enroulement principal 10, comportant optionnellement en plus des enroulements de compensation 20, 22, forment la première partie du capteur 5, et la portion centrale arrondie 14 forme la deuxième partie du capteur.

Avantageusement, les performances du capteur 5 sont préservées lors de l'ouverture et de la fermeture, la séparation des deux parties étant réalisée au niveau de l'élément ferromagnétique.

Le module 2 de mesure de courant comporte en outre un circuit de traitement électrique ou électronique 30, le capteur de courant 5 étant connecté au circuit de traitement 30.

Le circuit de traitement 30 est configuré pour traiter le courant électrique traversant l'enroulement de mesure, et comporte notamment un module d'intégration pour obtenir une mesure du courant électrique traversant le conducteur électrique 8.

Par exemple, le circuit de traitement 30 comporte notamment un filtre antirepliement, un bloc de conversion numérique-analogique, un bloc d'intégration temporelle du signal électrique pour obtenir une mesure de courant I(t) et un bloc de calcul de grandeurs électriques, par exemple des valeurs moyenne ou moyenne quadratique du courant électrique.

Avantageusement, lorsque l'élément ferromagnétique a une forme telle qu'illustrée dans les figure 1 et 2, avec un profil rectangulaire, le module de mesure de courant obtenu est particulièrement compact, et particulièrement adapté pour être intégré dans un boîtier parallélépipédique.

Un tel boîtier est aisé à fabriquer.

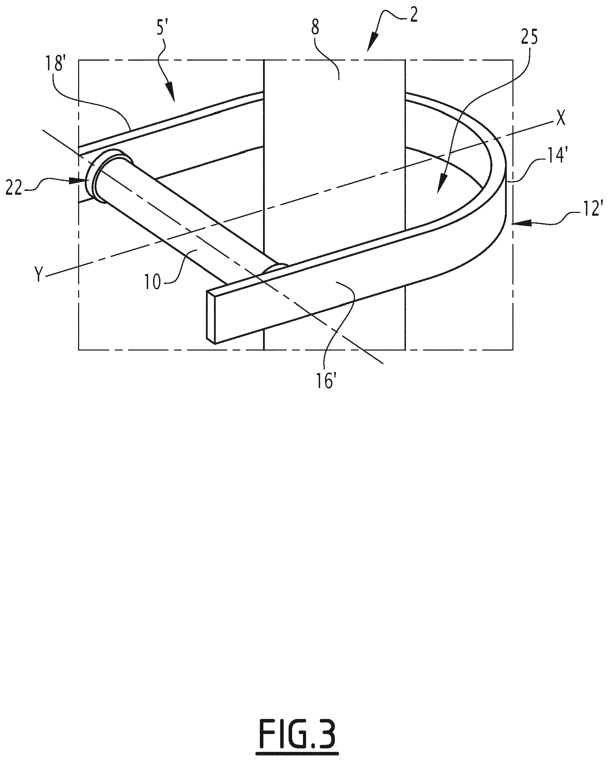

Un deuxième mode de réalisation, non revendiqué, d'un capteur de courant faisant partie d'un module de mesure de courant 2 est illustré à la figure 3.

Dans ce mode de réalisation, le capteur 5' comporte un élément ferromagnétique comportant une portion centrale arrondie 14' en forme d'arc de cercle.

Néanmoins, d'autres formes à symétrie par rapport à l'axe de symétrie X sont envisageables, par exemple la portion centrale arrondie 14' a une forme rectangulaire à coins arrondis, comme illustré dans la figure 2.

Dans ce deuxième mode de réalisation, l'élément ferromagnétique 12' est formé d'une pièce, en d'autres termes les bras respectifs 16', 18' sont venus de matière avec la portion centrale arrondie 14'.

Dans ce cas de figure, l'ouverture du capteur s'effectue par déplacement en translation le long de l'axe X de l'élément ferromagnétique 12' par rapport à l'enroulement principal 10, le cas échéant prolongé par les enroulements de compensation 20, 22. Ainsi, dans ce mode de réalisation, l'enroulement de mesure 10, 20, 22 forme la première partie du capteur 5', et l'élément ferromagnétique comprenant la portion centrale arrondie 14' et les bras 16', 18' forme la deuxième partie du capteur 5'.

Dans tous les modes de réalisation, le dimensionnement de l'élément ferromagnétique 12 est choisi en fonction des performances attendues et de l'encombrement acceptable.

Avantageusement, le capteur de courant 5 de dimensions d'environ 15mmx15mm dans le plan X,Y permet d'obtenir une performance de l'ordre de 250 mV/Amp à 50 Hz.

Le module de mesure de courant est séparable en deux parties, par conséquent il est ouvrant, ce qui permet une mise en place aisée autour d'un conducteur électrique sans nécessiter de débrancher ce conducteur.

La séparation en deux parties ne nécessite pas une ouverture des enroulements, ce qui rend le module de mesure de courant plus robuste à un nombre d'ouvertures et fermetures. Ainsi, sa manipulation par un opérateur est plus aisée.

Avantageusement, la forme incurvée de l'élément ferromagnétique est optimisée, ce qui permet d'optimiser les performances de mesure de courant, tout en respectant des contraintes d'encombrement.

## Revendications

1. Module (2) de mesure de courant électrique destiné à mesurer un courant électrique traversant un conducteur électrique (8), le module (2) comportant un enroulement principal (10) de fil conducteur d'électricité,
le module (2) de mesure de courant étant **caractérisé en ce qu'**il comporte en outre un élément ferromagnétique (12, 12') de forme incurvée, l'élément ferromagnétique (12, 12') comportant une portion centrale arrondie (14, 14') et deux bras (16, 18, 16', 18') de même longueur s'étendant de part et d'autre de la portion centrale arrondie (14, 14'), l'élément ferromagnétique (12, 12') ayant un axe de symétrie (X) parallèle à chacun des bras, l'enroulement principal (10) s'étendant selon une direction (Y) perpendiculaire audit axe de symétrie (X), et étant disposé entre lesdits bras (16, 18, 16', 18') de l'élément ferromagnétique (12, 12'), de manière à former un logement traversant (25) adapté pour entourer ledit conducteur électrique (8), le module (2) de mesure étant configuré pour s'ouvrir en deux parties, une première partie comportant au moins l'enroulement principal (10) et une deuxième partie comportant au moins la portion centrale arrondie (14, 14') de l'élément ferromagnétique (12, 12'), pour permettre une insertion dudit conducteur électrique (8) entre les deux parties, **caractérisé en ce que** ladite portion centrale arrondie (14) de l'élément ferromagnétique (12) forme ladite deuxième partie, séparable de chacun desdits bras (16,18), ladite première partie étant formée par les bras (16,18) et l'enroulement principal (10) fixé entre lesdits bras.

2. Module de mesure de courant selon la revendication 1, dans lequel l'enroulement principal (10) est réalisé par enroulement d'un fil conducteur sur un support de forme linéaire.

3. Module de mesure de courant selon la revendication 1 ou 2, dans lequel chacun desdits bras (16, 18) a une extrémité (15, 17) située à l'opposé de la portion centrale arrondie (14), et dans lequel ledit enroulement principal (10) est disposé à une même distance (d), selon la direction (X) de l'axe de symétrie, de l'extrémité (15, 17) de chaque bras (16, 18).

4. Module de mesure de courant selon l'une quelconque des revendications 1 à 3, dans lequel l'enroulement principal a une première extrémité et une deuxième extrémité, lesdits bras de l'élément ferromagnétique étant respectivement un premier bras (16) et un deuxième bras (18), le module de mesure comportant en outre des enroulements de compensation (20, 22), disposés de part et d'autre de l'enroulement principal (10), respectivement entre la première extrémité de l'enroulement principal et le premier bras et entre la deuxième extrémité de l'enroulement principal et le deuxième bras.

5. Module de mesure de courant selon l'une quelconque des revendications 1 à 4, dans lequel la portion centrale arrondie (14) a une forme rectangulaire à coins arrondis dans un plan longitudinal de l'élément ferromagnétique.

6. Module de mesure de courant selon l'une quelconque des revendications 1 à 4, dans lequel la portion centrale arrondie (14) a une forme d'arc de cercle dans un plan longitudinal de l'élément ferromagnétique.

7. Module de mesure de courant selon l'une quelconque des revendications 1 à 6, dans lequel ledit élément ferromagnétique est un alliage de fer-silicium ou de fer-nickel.

8. Module de mesure de courant selon l'une des revendications 1 à 7, comportant en outre un circuit de traitement (30), le fil conducteur de l'enroulement principal étant connecté au circuit de traitement (30), le circuit de traitement comportant notamment un intégrateur du signal électrique.

## Patentansprüche

1. Strommessmodul (2) zur Messung eines elektrischen Stroms, der durch einen elektrischen Leiter (8) fließt, wobei das Modul (2) eine Hauptwicklung (10) aus elektrisch leitendem Draht umfasst,
wobei das Strommessmodul (2) **dadurch gekennzeichnet ist, dass** es ferner ein ferromagnetisches Element (12, 12') mit gekrümmter Form umfasst, wobei das ferromagnetische Element (12, 12') einen abgerundeten zentralen Abschnitt (14, 14') und zwei gleich lange Arme (16, 18, 16', 18') umfasst, die sich beiderseits des abgerundeten zentralen Abschnitts (14, 14') erstrecken, wobei das ferromagnetische Element (12, 12') eine Symmetrieachse (X) aufweist, die zu jedem der Arme parallel ist, wobei sich die Hauptwicklung (10) entlang einer Richtung (Y) erstreckt, die senkrecht zu der genannten Symmetrieachse (X) ist, und zwischen den genannten Armen (16, 18, 16', 18') des ferromagnetischen Elements (12, 12') angeordnet ist, derart, dass sie eine durchgehende Aufnahme (25) bildet, die dazu geeignet ist, den genannten elektrischen Leiter (8) zu umgeben, wobei das Strommessmodul (2) so konfiguriert ist, dass es sich in zwei Teile öffnet, wobei ein erster Teil mindestens die Hauptwicklung (10) umfasst und ein zweiter Teil mindestens den abgerundeten zentralen Abschnitt (14, 14') des ferromagnetischen Elements (12, 12') umfasst, um ein Einführen des genannten elektrischen Leiters (8) zwischen die beiden Teile zu ermöglichen, **dadurch gekennzeichnet, dass** der genannte abgerundete zentrale Abschnitt (14) des ferromagnetischen Elements (12) den genannten zweiten Teil bildet, der von jedem der genannten Arme (16,18) trennbar ist, wobei der genannte erste Teil durch die Arme (16,18) und die zwischen den genannten Armen befestigte Hauptwicklung (10) gebildet ist.

2. Strommessmodul nach Anspruch 1, wobei die Hauptwicklung (10) durch Wickeln eines leitenden Drahts auf einen Träger mit linearer Form hergestellt ist.

3. Strommessmodul nach Anspruch 1 oder 2, wobei jeder der genannten Arme (16, 18) ein Ende (15, 17) aufweist, das dem abgerundeten zentralen Abschnitt (14) gegenüberliegt, und wobei die genannte Hauptwicklung (10) in einer gleichen Entfernung (d) entlang der Richtung (X) der Symmetrieachse von dem Ende (15, 17) jedes Arms (16, 18) angeordnet ist.

4. Strommessmodul nach einem der Ansprüche 1 bis 3, wobei die Hauptwicklung ein erstes Ende und ein zweites Ende aufweist, wobei die genannten Arme des ferromagnetischen Elements jeweils ein erster Arm (16) und ein zweiter Arm (18) sind, wobei das Strommessmodul ferner Kompensationswicklungen (20, 22) umfasst, die beiderseits der Hauptwicklung (10) angeordnet sind, und zwar jeweils zwischen dem ersten Ende der Hauptwicklung und dem ersten Arm sowie zwischen dem zweiten Ende der Hauptwicklung und dem zweiten Arm.

5. Strommessmodul nach einem der Ansprüche 1 bis 4, wobei der abgerundete zentrale Abschnitt (14) in einer Längsebene des ferromagnetischen Elements eine rechteckige Form mit abgerundeten Ecken aufweist.

6. Strommessmodul nach einem der Ansprüche 1 bis 4, wobei der abgerundete zentrale Abschnitt (14) in einer Längsebene des ferromagnetischen Elements die Form eines Kreisbogens aufweist.

7. Strommessmodul nach einem der Ansprüche 1 bis 6, wobei das genannte ferromagnetische Element eine Eisen-Silizium- oder Eisen-NickelLegierung ist.

8. Strommessmodul nach einem der Ansprüche 1 bis 7, ferner umfassend eine Verarbeitungsschaltung (30), wobei der leitende Draht der Hauptwicklung mit der Verarbeitungsschaltung (30) verbunden ist, wobei die Verarbeitungsschaltung insbesondere einen Integrator des elektrischen Signals umfasst.

## Claims

1. Current measurement module (2) for measuring an electric current passing through an electrical conductor (8), the module (2) comprising a main winding (10) of electrically conductive wire,
the current measurement module (2) being **characterized in that** it further comprises a ferromagnetic element (12, 12') of curved shape, the ferromagnetic element (12, 12') comprising a rounded central portion (14, 14') and two arms (16, 18, 16', 18') of the same length extending on either side of the rounded central portion (14, 14'), the ferromagnetic element (12, 12') having an axis of symmetry (X) parallel to each of the arms, the main winding (10) extending along a direction (Y) perpendicular to said axis of symmetry (X), and being disposed between said arms (16, 18, 16', 18') of the ferromagnetic element (12, 12'), so as to form a through housing (25) suitable for surrounding said electrical conductor (8), the measurement module being configured to open into two parts, a first part comprising at least the main winding (10) and a second part comprising at least the rounded central portion (14, 14') of the ferromagnetic element (12, 12'), to allow insertion of said electrical conductor (8) between the two parts, **characterized in that** said rounded central portion (14) of the ferromagnetic element (12) forms said second part, separable from each of said arms (16,18), said first part being formed by the arms (16,18) and the main winding (10) fixed between said arms.

2. Current measurement module according to claim 1, wherein the main winding (10) is produced by winding a conductive wire on a support of linear shape.

3. Current measurement module according to claim 1 or 2, wherein each of said arms (16, 18) has an end (15, 17) located opposite the rounded central portion (14), and wherein said main winding (10) is disposed at a same distance (d), along the direction (X) of the axis of symmetry, from the end (15, 17) of each arm (16, 18).

4. Current measurement module according to any one of claims 1 to 3, wherein the main winding has a first end and a second end, said arms of the ferromagnetic element being respectively a first arm (16) and a second arm (18), the measurement module further comprising compensation windings (20, 22), disposed on either side of the main winding (10), respectively between the first end of the main winding and the first arm and between the second end of the main winding and the second arm.

5. Current measurement module according to any one of claims 1 to 4, wherein the rounded central portion (14) has a rectangular shape with rounded corners in a longitudinal plane of the ferromagnetic element.

6. Current measurement module according to any one of claims 1 to 4, wherein the rounded central portion (14) has the shape of a circular arc in a longitudinal plane of the ferromagnetic element.

7. Current measurement module according to any one of claims 1 to 6, wherein said ferromagnetic element is a ferrosilicon or ferronickel alloy.

8. Current measurement module according to one of claims 1 to 7, further comprising a processing circuit (30), the conductive wire of the main winding being connected to the processing circuit (30), the processing circuit comprising in particular a electrical signal integrator.
